Europäisches Patentamt

European Patent Office

Office européen des brevets

(11) Veröffentlichungsnummer: **0 437 654 A1**

## (12) EUROPÄISCHE PATENTANMELDUNG

(21) Anmeldenummer: 90100835.9

(22) Anmeldetag: 16.01.90

(51) Int. Cl.⁵: **H01L 35/18**, H01L 35/20, H01L 35/22, H01L 35/32

(43) Veröffentlichungstag der Anmeldung:
24.07.91 Patentblatt 91/30

(84) Benannte Vertragsstaaten:
**DE FR GB IT NL**

(71) Anmelder: **Dahlberg, Reinhard, Dr.**
**Innere Bergstrasse 32**
**W-7101 Flein(DE)**

(72) Erfinder: **Dahlberg, Reinhard, Dr.**
**Innere Bergstrasse 32**
**W-7101 Flein(DE)**

(54) **Thermoelement-Schenkel mit richtungsabhängiger Quantisierung der Ladungsträger.**

(57) Es wird ein Thermoelement-Schenkel (10) beschrieben, der aus einer Struktur von multiplen alternierenden dünnen Schichten (2, 3) Drähten (8') oder Filmen (7) besteht, welche parallel zum Wärmestrom (1) durch den Thermoelement-Schenkel (10) orientiert sind. Die freie Weglänge oder die De Broglie-Wellenlänge des Ladungsträger-Gases in der Struktur ist größer als die Dicke der Schichten (2, 3), Drähte (8') oder Filme (7). Das Ladungsträger-Gas ist deshalb senkrecht zum Wärmestrom (1) durch den Thermoelement-Schenkel (10) quantisiert, in Richtung des Wärmestromes dagegen frei. Im Falle von Halbleiter-Übergitter-Strukturen mit zweidimensionalem oder eindimensionalem Ladungsträger-Gas ergibt sich als Folge der höheren Beweglichkeit parallel zum Wärmestrom (1) insgesamt eine höhere elektrische Leitfähigkeit verglichen mit entsprechenden isotropen Thermoelement-Schenkeln (10, 11). Im Falle von alternierenden dünnen Metall-Filmen (7) oder -Drähten (8') in einer Isolatormatrix (9) ergibt sich als Folge geringerer Ladungsträger-Dichte und erhöhter Ladungsträger-Streuung in Richtung des Wärmestromes (1) durch den Thermoelement-Schenkel (10) ein größerer spezifischer elektrischer und Wärmewiderstand als im massiven Metall - aber auch eine erhöhte differentielle Thermokraft. Beide Fälle des Thermoelement-Schenkels der Erfindung mit einer richtungsabhängigen Quantisierung des Ladungsträger-Gases können zu einer Vergrößerung des thermoelektrischen Wirkungsgrades führen.

FIG.1

EP 0 437 654 A1

## THERMOELEMENT-SCHENKEL MIT RICHTUNGSABHÄNGIGER QUANTISIERUNG DER LADUNGSTRÄGER

Die Vergrößerung des Wirkungsgrades der thermoelektrischen Umwandlung von Wärme in elektrische Energie ist eine wichtige Aufgabe der Festkörperphysik. Die bisher erzielten Fortschritte sind vor allem durch die Schaffung von Halbleiter-Thermoelementen erreicht worden. Es hat sich gezeigt, daß die entscheidende Kenngröße für den Wirkungsgrad thermoelektrischer Materialien die "Effektivität"

$$\chi = \frac{\alpha^2}{\lambda \cdot \rho}$$

ist. Sie ist das Quadrat der differentiellen Thermokraft $\alpha$ [$\mu V/°K$] dividiert durch das Produkt aus spez. Wärmeleitfähigkeit

$$\lambda \ [\frac{Watt}{°K \cdot cm}]$$

und dem spez. el. Widerstand $\rho$ [$\Omega cm$]. Das Produkt aus der Effektivität $\chi$ und der absoluten Temperatur T ist eine dimensionslose Zahl: der Arbeitsfaktor A. Bezogen auf ein ganzes Thermoelement läßt sich bei optimaler Konstruktion des Thermoelements (d. h., wenn sich die elektrischen Widerstände beider Schenkel zueinander umgekehrt verhalten wie die entsprechenden Wärmewiderstände) für den Arbeitsfaktor schreiben:

$$A = \frac{\alpha^2}{(\sqrt{L_p} + \sqrt{L_n})^2}$$

mit den LORENZ-Zahlen

$$L_{p,n} = \frac{\lambda_{p,n} \cdot \rho_{p,n}}{T}$$

Der spez. elektrische Widerstand $\rho$ sollte eigentlich zur Erzielung maximaler Effektivität möglichst klein sein. Damit die differentielle Thermokraft jedoch nicht zu stark abnimmt, darf die Ladungsträger-Konzentration höchstens an der Grenze zur Entartung liegen. Durch diese optimale Konzentration der Ladungsträger sind die differentielle Thermokraft $\alpha$ und der spez. el. Widerstand $\rho$ festgelegt. Es bleibt deshalb für eine Vergrößerung von A nur noch die mögliche Verkleinerung der spezifischen Wärmeleitung $\lambda$ - genauer, deren Gitteranteil übrig. Dieser Weg der Verbesserung von A ist in der Vergangenheit durch den Einbau von Störzentren und durch Mischkristallbildung praktisch ausgereizt worden. Eine weitere Verbesserung von A und damit vom thermoelektrischen Wirkungsgrad der Umwandlung von Wärme in elektrische Energie ist nur von neuen Effekten zu erwarten.

Die vorliegende Erfindung geht von der Überzeugung aus, daß die moderne Festkörperphysik mit den Quanteneffekten und den Methoden zu deren makroskopischer Nutzung auch bereits die Mittel zu einer weiteren Verbesserung des Wirkungsgrades der thermoelektrischen Effekte bereit gestellt hat. In den z. B. mit Hilfe der Molekularstrahl-Epitaxie (MBE) erzeugten "Übergittern" aus dotierten und undotierten Halbleiterschichten unterschiedlichen Bandabstandes mit Schichtdicken von z. B. 5 $10^{-7}$ cm entsteht - energetisch gesehen - ein zweidimensionales Ladungsträgergas in den undotierten Schichten. Senkrecht zu den Schichten ist es in einem eindimensionalen Quanten-Trog (quantum-well) mit definierter Tiefe eingeschlossen. In Richtung der Schichten kann es sich dagegen frei und mit wesentlich größerer Beweglichkeit bewegen, als es sich in dem dotierten Halbleitermaterial bewegen kann. Das zweidimensionale Ladungsträgergas kann z. B. 20 % des Übergitter-Volumens ausfüllen. Seine Beweglichkeit aber kann um mehr als 2 Größenordnungen größer sein als in dem hochdotierten Halbleitermaterial. Damit hat aber dieses Übergitter - parallel zu den Schichten gemessen - einen "spezifischen elektrischen Widerstand" , der mehr als zwanzigmal kleiner ist, als es der spez. el. Widerstand eines Thermoelement-Schenkels wäre, der ganz aus dem dotierten Halbleitermaterial gebildet wäre. Selbst wenn die differentielle Thermokraft im Übergitter trotz der sehr viel größeren Beweglichkeit in den undotierten Schichten nicht erhöht ist, und wenn auch die Gitterwärmeleitung nicht reduziert ist, dann bleibt als Folge der vergrößerten elektrischen Leitfähigkeit ein wesentlich verbessertes Verhältnis von elektronischer - zur Gitter-Wärmeleitfähigkeit. D. h., die LORENZ-Zahl L dieses Thermoschenkels ist kleiner und seine Effektivität größer. Noch ausgeprägter ist dieses Verhältnis für Übergitterstrukturen mit "Quanten-Drähten" - also eindimensionalem Ladungsträger-Gas -, die neuerdings technologisch machbar sind [1] .

[1] S. J. Allen, Jr., P. Bastos, H. M. Cox, F. De Rosa, D. M. Hwang und L. Nazar

Aber nicht nur einkristalline oder passivierte polykristalline Halbleiter-Übergitterstrukturen können gemäß der Lehre der vorliegenden Erfindung für die Vergrößerung des thermoelektrischen Wirkungsgrades

Literatur:
nutzbar gemacht werden. Es ist seit langem bekannt, daß bei dünnen Metall-Filmen und Metall-Drähten der elektrische Widerstand in Längsrichtung der Filme und Drähte als Folge zusätzlicher Streuung der Ladungsträger an den Grenzflächen vergrößert ist. Außerdem ist im allgemeinen in dünnen metallischen Filmen und dünnen Drähten die Zahl der freien Ladungsträger pro Atom nicht die gleiche wie im massiven Metall. Diese Änderung der Zahl der freien Ladungsträger wird durch eine strukturelle Verschiedenheit der dünnen Metall-Filme oder -Drähte (lockere Packung) gegenüber dem massiven Metall hervorgerufen. Sie kann aber auch allein schon durch die in der Oberfläche der dünnen Schicht oder des dünnen Drahtes befindlichen Atome verursacht werden. Die Energiebänder dieser Grenzflächenatome liegen anders als bei den Atomen im Inneren. Die dadurch entstehenden Oberflächenzustände können als Fang- oder Spenderstellen für Ladungsträger wirken. Sie können eine temperaturabhängige Verminderung oder Erhöhung der Zahl der freien Ladungsträger pro Atom erzeugen. Die differentielle Thermokraft ist bekanntlich umgekehrt proportional der Fermi-Grenzenergie. Die Fermi-Grenzenergie aber ist eine Funktion der Zahl der freien Ladungsträger. Damit wird aber die differentielle Thermokraft zwischen zwei Metallen durch die in diesen vorhandenen Zahlen der freien Ladungsträger pro Atom bestimmt. Da die differentielle Thermokraft im Gegensatz zum spezifischen elektrischen Widerstand quadratisch in den Arbeitsfaktor A eingeht, kann auch eine parallele Struktur von alternierenden dünnen Metall-Filmen und Isolator-Filmen oder dünnen parallelen Metall-Drähten in einer Isolator- oder Halbleiter-Matrix eine höhere thermoelektrische Effektivität aufweisen als ein massiver Thermoelement-Schenkel aus dem gleichen Metall. Senkrecht zu den Metall-Filmen oder -Drähten ist das Ladungsträger-Gas auch bei diesen Strukturen aus multiplen alternierenden metallischen Filmen oder Drähten in einem eindimensionalen quadratischen Trog eingeschlossen und quantisiert.

Zur Verbesserung des thermoelektrischen Wirkungsgrades schlägt die Erfindung deshalb einen Thermoelement-Schenkel mit richtungsabhängiger Quantisierung der Ladungsträger vor, der dadurch gekennzeichnet ist, daß ein Thermoelement-Schenkel aus einer Struktur von multiplen alternierenden dünnen Schichten, Drähten oder Filmen besteht, welche parallel zum Wärmestrom durch den Thermoelement-Schenkel verlaufen, daß die Dicke der dünnen Schichten, Drähte oder Filme kleiner ist, als die freie Weglänge oder die De Broglie-Wellenlänge der Ladungsträger in den dünnen Schichten, Drähten oder Filmen, so daß die Bewegung der Ladungsträger senkrecht zum Wärmestrom durch den Thermoschenkel mindestens in einer Richtung quantisiert ist, und daß die Bewegung der Ladungsträger parallel zum Wärmestrom durch den Thermoelement-Schenkel frei ist.

Die Struktur von multiplen dünnen Schichten kann durch ein Übergitter von alternierenden Schichten aus dotiertem Halbleitermaterial und nichtdotiertem oder nur schwach dotiertem Halbleitermaterial mit geringerem Bandabstand als das hochdotierte Halbleitermaterial gebildet sein.

Eine Struktur von multiplen alternierenden dünnen Halbleiter-Drähten kann durch eine dotierte Halbleitermatrix gebildet sein, in welche parallele einkristalline Drähte aus nichtdotiertem oder nur schwach dotiertem Halbleitermaterial mit kleinerem Bandabstand als das dotierte Halbleitermaterial eingebettet sind.

Eine Struktur von multiplen alternierenden dünnen metallischen Filmen oder dünnen metallischen Drähten kann erfindungsgemäß auch durch Isolator-Filme oder hochohmige Halbleiterfilme gebildet sein, welche abwechselnd mit dünnen metallisch leitenden Filmen ein Filmpaket bilden, oder von parallelen dünnen metallisch leitenden Drähten gebildet sein, welche in eine Isolator- oder Halbleitermatrix eingebettet sind.

Eine Struktur aus multiplen dünnen Drähten oder Filmen kann nach der Erfindung dadurch erzeugt sein, daß in einen Isolator oder in einen hochohmigen Halbleiter eine Vielzahl von parallelen metallisch leitenden Drähten, Filmen oder Pulverteilchen eingebettet ist, daß die Dicke dieser Drähte, Filme oder Pulverteilchen größer als die freie Weglänge oder die De Broglie-Wellenlänge der Ladungsträger in diesen Drähten, Filmen oder Pulverteilchen ist, und daß durch mechanisches Rollen, Ziehen, Walzen oder Pressen bei erhöhter Temperatur die Dimensionen des gesamten Einbettungssystems so verändert sind, daß die resultierende Dicke der eingebetteten Drähte, Filme oder der zu Drähten verformten Pulverteilchen kleiner als die freie Weglänge oder die De Broglie-Wellenlänge der Ladungsträger ist.

Die Struktur von multiplen dünnen Schichten oder dünnen Halbleiter-Drähten in einer Halbleiter-Matrix kann aus Elementhalbleitern oder Verbindungshalbleitern wie z. B. III/V-Verbindungen IV/IV-

"Filamentary structure and transport in corrugated levitation epitaxy"
J. Appl. Phys. 66 (3), 1222 - 1226 (1989)

InGaAs/InP superlattices grown by vapor

Mischkristallen, IV/IV-Verbindungen oder II/VI-Verbindungen gebildet sein.

Die metallisch leitenden parallelen dünnen Drähte oder Filme können aus Metallen, Legierungen oder auch aus metallisch leitenden Verbindungen wie Carbiden, Boriden, Nitriden, Sulfiden, Seleniden, Telluriden, Oxiden oder deren Verbindungen bestehen. Die Isolator-Matrix oder hochohmige Halbleiter-Matrix bzw. die dünnen Isolatorfilme oder die dünnen hochohmigen Halbleiterfilme können aus Gläsern, organischen Kunststoffen, Oxiden, Nitriden, Sulfiden, Seleniden, Telluriden, Chloriden, Fluoriden, Elementhalbleitern oder Verbindungshalbleitern bestehen.

Die Strukturen von multiplen alternierenden dünnen Schichten, Drähten oder Filmen können in ansich bekannter Weise mit Hilfe von Molekularstrahl-Epitaxie, metallorganischem Abscheiden aus der Gasphase, durch Aufdampfen im Hochvakuum, durch Aufsputtern, durch reaktives Sputtern, durch elektrochemisches Abscheiden, durch elektrochemisches Passivieren bzw. durch eine Kombination dieser Methoden hergestellt sein.

Thermoelement-Schenkel gemäß der Erfindung lassen sich mit Vorteil in ansich bekannter Weise zum Bau von Peltier-Elementen benutzen. Damit ist die Herstellung von Geräten und Anlagen zur reversiblen Kühlung und Heizung sowie von geräuschlosen Klima-Anlagen mit hohem Wirkungsgrad möglich.

Auch der Bau von Thermoelementen aus Thermoelement-Schenkeln gemäß der Erfindung ist in konventioneller Weise durchführbar. Diese Thermoelemente erlauben die Umwandlung von Wärme in elektrische Energie mit hohem Wirkungsgrad, z. B. für meßtechnische oder nachrichtentechnische Zwecke. Für eine Vielzahl von praktischen Anwendungen ist auch die Herstellung von stationären und beweglichen Thermogeneratoren jeder Größe mit hohen Wirkungsgraden möglich.

Im folgenden soll die Erfindung anhand von 7 Ausführungsbeispielen näher erläutert werden:

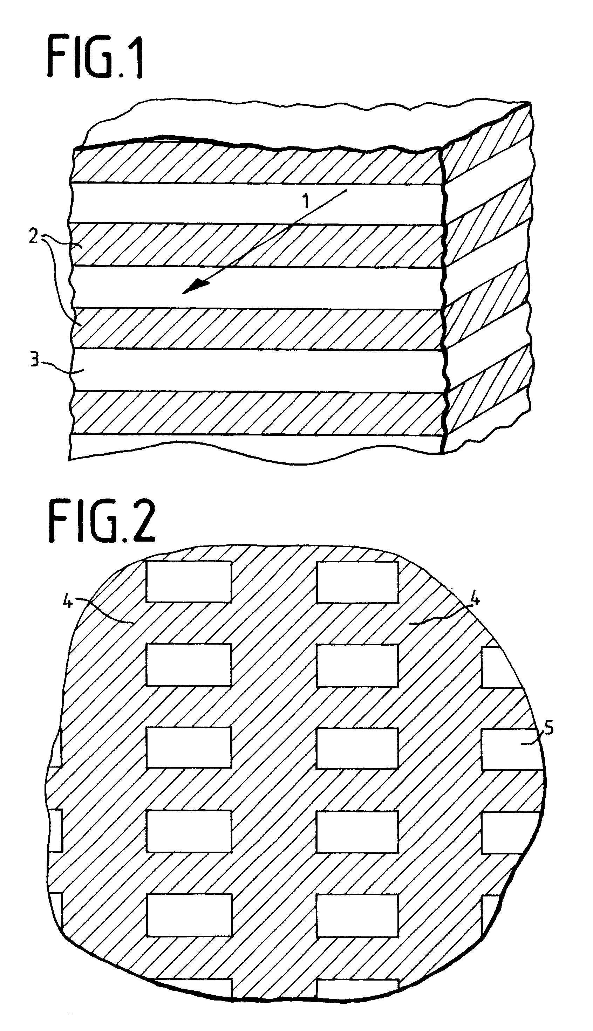

Ausführungsbeispiel 1 zeigt in Fig. 1 einen Ausschnitt aus einem p-leitenden Thermoelement-Schenkel der Erfindung mit einer Struktur von multiplen alternierenden dünnen Schichten.

Ausführungsbeispiel 2 zeigt in Fig. 2 einen Querschnitt durch einen n-leitenden Thermoelement-Schenkel der Erfindung mit einer multiplen Struktur von dünnen Halbleiter-Drähten in einer Halbleiter-Matrix.

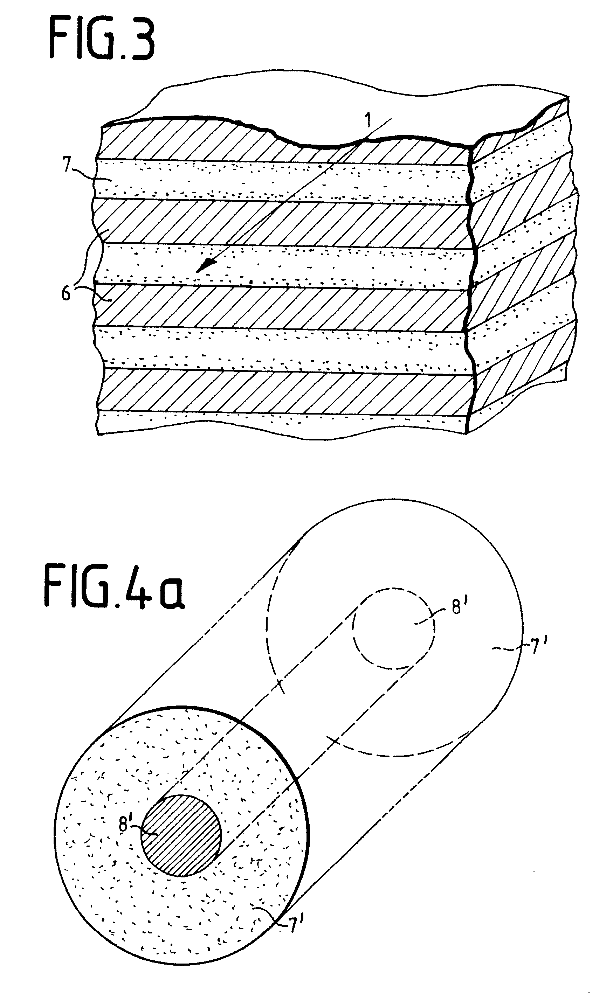

Ausführungsbeispiel 3 zeigt in Fig. 3 einen Ausschnitt aus einem p-leitenden Thermoelement-Schenkel der Erfindung mit einer Struktur von multiplen dünnen alternierenden Filmen aus ZnS und ZnSb.

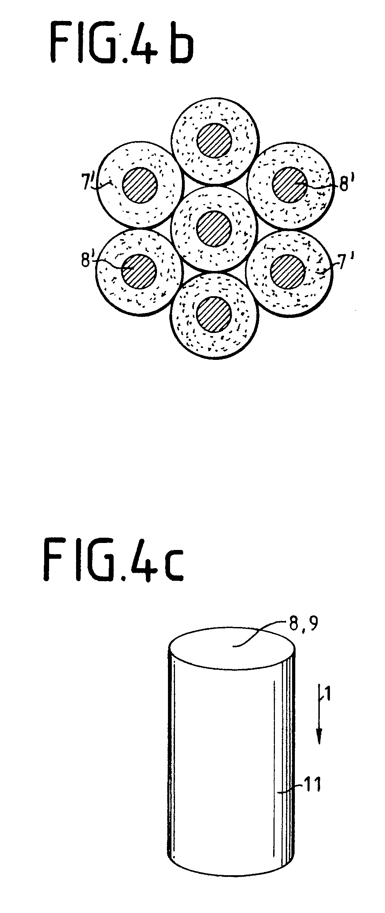

Ausführungsbeispiel 4 zeigt in Fig. 4 einen Ausschnitt aus einem n-leitenden Thermoelement-Schenkel mit einer Struktur von multiplen dünnen parallelen Drähten aus $Ni_{55}Cu_{44}Mn_1$, welche in eine Glasmatrix eingebettet sind.

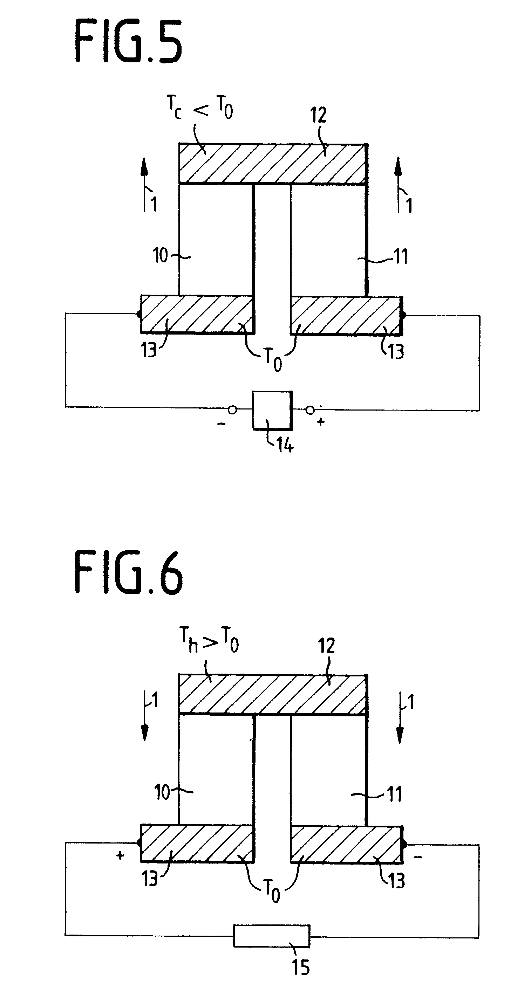

Ausführungsbeispiel 5 zeigt in Fig. 5 ein Peltier-Element gemäß der Erfindung mit Thermoelement-Schenkeln, welche aus Strukturen von multiplen dünnen Filmen bestehen.

Ausführungsbeispiel 6 zeigt in Fig. 6 ein Thermoelement gemäß der Erfindung mit Thermoelement-Schenkeln, welche aus Strukturen von multiplen dünnen polykristallinen, passivierten Halbleiterschichten gebildet sind.

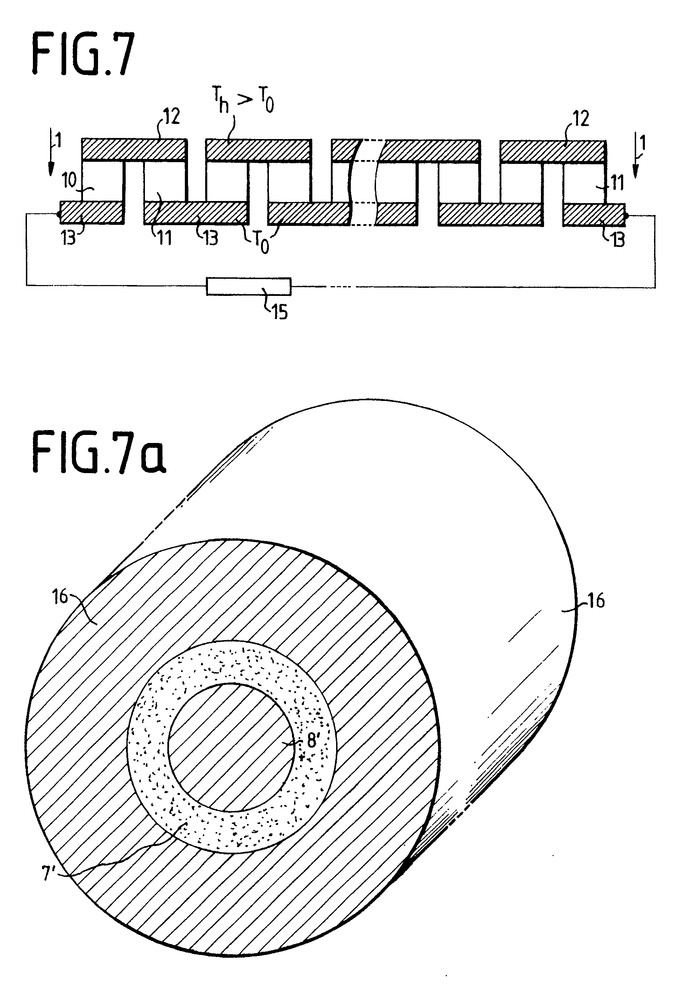

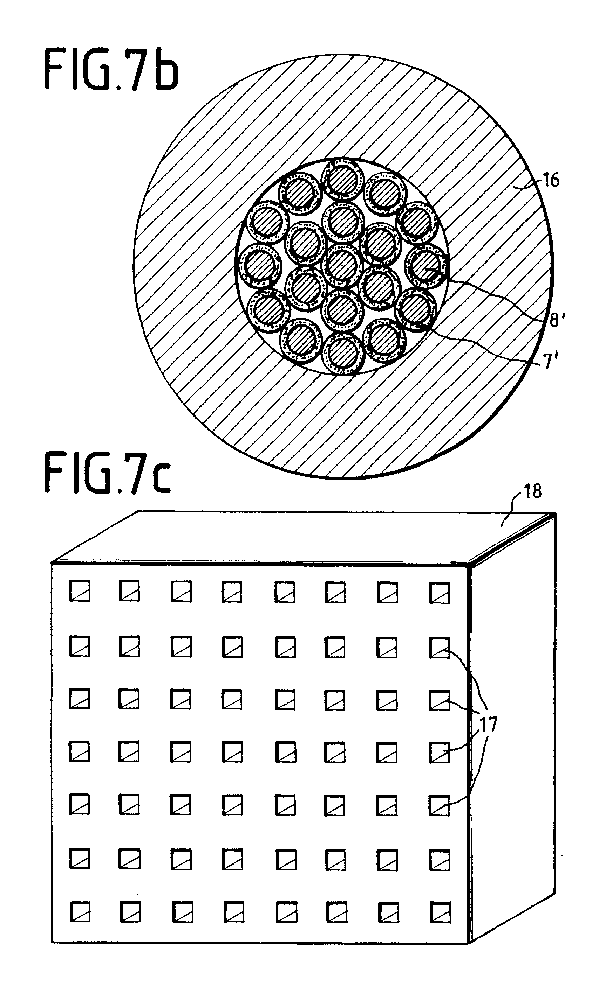

Ausführungsbeispiel 7 zeigt in Fig. 7 einen Thermogenerator, der aus Thermoelement-Schenkeln aufgebaut ist, welche eine Struktur von multiplen parallelen dünnen Eisendrähten bzw. Nickeldrähten in einer Bornitrid-Matrix aufweisen.

Ausführungsbeispiel 1

In Fig. 1 bedeuten 2 dünne Schichten aus $n^+$-$Al_xGa_{1-x}As$ (x < 0,4). Ihre Dicke beträgt $5 \cdot 10^{-7}$ cm. 3 sind undotierte Schichten aus GaAs, welche gleichfalls $5 \cdot 10^{-7}$ cm dick sind. 2 und 3 bilden eine alternierende Folge von Schichten eines Übergitters, aus welchen ein Thermoelement-Schenkel gebildet ist. Fig. 1 zeigt einen Ausschnitt aus diesem Schichtpaket. Der Wärmestrom 1 durch den Thermoelement-Schenkel hat die gleiche Richtung wie die Schichten 2 und 3. Da der Bandabstand im Material der Schicht 2 etwas größer ist als beim Material der Schicht 3, bildet sich in den Schichten 3 ein zweidimensionales Elektronengas, dessen Bewegung in einer Richtung senkrecht zu den Schichten quantisiert ist. In Richtung der Schichten und in Richtung des Wärmestroms 1 ist das Elektronengas frei. Da die Schichten 3 undotiert sind, ist die Beweglichkeit der Elektronen in Richtung des Wärmestroms größer als im hochdotierten Material 2. Der Thermoelement-Schenkel mit seiner Struktur aus $3 \cdot 10^5$ Doppelschichten ist mit Hilfe einer Langzeit-Molekularstrahl-Epitaxie hergestellt. Der Querschnitt des Thermoelement-Schenkels beträgt 3 x 3 mm², seine Länge 5 mm. Er ist durch Heraussägen aus dem epitaktischen Schichtpaket hergestellt. An den langen Enden ist der Thermoelement-Schenkel senkrecht zum Schichtenpaket sperrfrei kontaktiert.

Ausführungsbeispiel 2

Fig. 2 zeigt eine Struktur von multiplen dünnen Quantendrähten 5 aus nichtdotiertem InGaAs, welche eingebettet ist in eine Halbleitermatrix 4 aus dotiertem InP. Die Dicke der Quantendrähte 5 beträgt $5 \cdot 10^{-6}$ cm. Ihre Richtung in der Halbleitermatrix 4 verläuft parallel zum Wärmestrom, welcher in Fig. 2 senkrecht zur Betrachtungsebene verläuft. Diese Struktur der multiplen parallelen Quantendrähte 5 in einer dotierten Halbleitermatrix 4 kommt durch eine Instabilität beim Wachstum von InGaAs/InP-Doppelschichten auf leicht fehlorientiertem Substrat mit Hilfe der Molekularstrahl-Epitaxie zustande. In den InGaAs-Drähten 5 ist das Elektronengas eingeschlossen. Seine Bewegung senkrecht zu den Drähten ist quantisiert. In Richtung der Drähte ist die Bewegung des Elektronengases frei und weist sehr hohe Werte der Beweglichkeit auf.

Ausführungsbeispiel 3

Fig. 3 zeigt eine Struktur von multiplen alternierenden dünnen Filmen, welche Teil eines Thermoelement-Schenkels ist. Auf hochohmige Halbleiter-Filme 7 aus ZnS sind alternierende metallisch leitende Filme 6 aus ZnSb aufgebracht. Die Film-Folge ist durch Hochfrequenz-Sputtern erzeugt. Um eine größere Gleichmäßigkeit der Film-Folgen zu erzielen, ist die Unterlage beim Sputtern auf 78 $^\circ$K gekühlt worden. Die Dicke der ZnS-Filme 7 beträgt $8 \cdot 10^{-7}$ cm und die Dicke der ZnSb-Filme 6 ist $1,2 \cdot 10^{-6}$ cm. Das fertige Schichtpaket ist unter einem allseitigen mechanischen Druck von 1000 kg/cm$^2$ von 78 $^\circ$K langsam auf eine Temperatur von 500 $^\circ$K erwärmt worden. Die ZnSb-Filme weisen einen um den Faktor 10 höheren spezifischen Widerstand und eine um den Faktor 5 höhere differentielle Thermokraft auf als massives polykristallines ZnSb. Der Wäremestrom 1 fließt parallel zu den Filmen 6 und 7 durch den Thermoschenkel. Da auch die spezifische Wärmeleitfähigkeit im Thermoschenkel gegenüber massivem polykristallinem ZnSb um eine Größenordnung kleiner ist, ist die Effektivität des Thermoelment-Schenkels um den Faktor 25 größer als von einem Thermoelement-Schenkel aus massivem polykristallienem ZnSb.

Ausführungsbeispiel 4

In Fig. 4a ist ein Draht 8' aus der Legierung $Ni_{55}Cu_{44}Mn_1$ ("Konstantan") mit einem Durchmesser von 1 mm mit einer Glas-Schicht 9 ummantelt, die ebenfalls 1 mm dick ist. Der thermische Ausdehnungskoeffizient des Glases ist dem thermischen Ausdehnungskoeffizienten des Drahtes 8' in einem größeren Temperaturbereich angepaßt. Dieser Glasmantel-Draht hat eine Länge von 100 cm und eine Dicke von 3 mm. Sieben Stück dieser Drähte sind entsprechend Fig. 4b zusammengelegt und so hoch erhitzt, daß das Glas 9 die gleiche plastische Verformbarkeit besitzt wie der Metalldraht 8'. In diesem Zustand wird das Bündel aus sieben ummantelten Drähten gemeinsam und gleichmäßig in mehreren Stufen durch entsprechende Ziehwerkzeuge bis auf einen Gesamt-Durchmesser von 3 mm und eine Länge von ca. 700 cm gezogen. Diese 700 cm werden danach in sieben gleiche Längenabschnitte zerteilt, wieder gemäß Fig. 4b zusammengelegt und wieder bei einer Temperatur gleicher Verformbarkeit bis auf einen Gesamt-Durchmesser von 3 mm gezogen. Dieser Prozeß des Zusammenlegens von sieben ummantelten Drähten, und das nachfolgende Ziehen auf 3 mm Gesamt-Durchmesser wird insgesamt elfmal hintereinander durchgeführt. Nach dem elften Ziehen auf 3 mm Gesamtdurchmesser haben die Drähte 8 rein rechnerisch nur noch einen Durchmesser von $1,7 \cdot 10^{-6}$ cm. Nach der elften Ziehstufe wird der 3 mm dicke Ziehstrang in mehr als 100 n-leitende Thermoelement-Schenkel von 5 mm Länge getrennt. Die Trennflächen werden durch aufgedampfte Chrom- und Goldschichten kontaktiert und können hartgelötet werden. Fig. 4c zeigt schematisch einen Thermoschenkel mit der Richtung des Wärmestromes 1. Durch Verwendung von Drähten 8' aus $Ni_{80}Cr_{20}$ und einer Glasummantelung aus anderem - an diese Legierung angepaßtem - Glas können nach dem gleichen Verfahren aber bei höheren Zieh-Temperaturen auch p-leitende Thermoschenkel hergestellt werden. Der Thermoelement-Schenkel gemäß Fig. 4c enthält mehr als $1,9 \cdot 10^9$ parallele Drähte 8 in denen die mittlere freie Weglänge der Ladungsträger größer ist als der mittlere Durchmesser der Drähte 8. Als Folge davon zeigen die Drähte 8 einen wesentlich höheren (und auch spannungsabhängigen) elektrischen und Wärme-Widerstand sowie eine differentielle Thermospannung, die eine Größenordnung höher ist als bei der massiven Legierung $Ni_{55}Cu_{44}Mn_1$. Die Effektivität des Thermoelement-Schenkels ist dadurch um den Faktor 100 größer als die Effektivität der massiven Legierung $Ni_{55}Cu_{44}Mn_1$.

Ausführungsbeispiel 5

Fig. 5 zeigt schematisch ein Peltier-Element mit einem p-Schenkel 10 und einem n-Schenkel 11 gemäß der Erfindung. Der p-Schenkel 10 besteht aus alternierenden dünnen ZnS-Filmen 7 und ZnSb-Filmen 6 gemäß Fig. 3. Die Dicke der ZnSb-Filme beträgt $1,2 \cdot 10^{-6}$ cm, die Dicke der ZnS-Filme $8 \cdot 10^{-7}$ cm. Der p-Schenkel 10 enthält $2 \cdot 10^5$ ZnS- und ZnSb-Filme, die parallel zum Wärmestrom 1 verlaufen. Der n-Schenkel 11 besteht analog zu Fig. 3 aus alternierenden ThF$_4$-Filmen 7 und Bi$_{78}$Sb$_{12}$-Filmen 6. Die Dicke der ThF$_4$-Filme 7 beträgt $1,5 \cdot 10^{-6}$ cm. Die Dicke der Bi$_{78}$Sb$_{12}$-Filme 6 beträgt $2,5 \cdot 10^{-6}$ cm. Der n-Schenkel 11 enthält $1 \cdot 10^5$ ThF$_4$- und Bi$_{78}$Sb$_{12}$-Filme, die ebenfalls parallel zum Wärmestrom 1 verlaufen. Der p-Schenkel 10 und der n-Schenkel 11 haben eine Dicke von 4 mm bei quadratischen Querschnitt und eine Länge von 6 mm. Sie sind über die metallische Brücke 12 elektrisch leitend miteinander verbunden. Ihre anderen Enden tragen elektrisch-thermische Kontakte 13, die auf der Temperatur $T = T_0$ festgehalten sind. Über die Stromquelle 14 wird ein Gleichstrom durch das Peltier-Element geschickt. Als Folge dieses Gleichstromes kühlt sich die metallische Brücke auf die Temperatur $T_C < T_0$ ab. Da die Thermoelement-Schenkel 10 und 11 des Peltier-Elements Effektivitäten haben, die etwa um den Faktor 25 größer sind als die Effektivitäten von massivem ZnSb bzw. $Bi_{78}Sb_{12}$, beträgt der Arbeitsfaktor des Peltier-Elements ungefähr $A \approx 7,5$ und die tiefste erzielbare Temperatur wird $T_C \geqq 103 \,^{\circ} K$ bei $T_0 = 300 \,^{\circ} K$.

Ausführungsbeispiel 6

Fig. 6 zeigt schematisch ein Thermoelement mit einem p-Schenkel 10 und einem n-Schenkel 11 gemäß der Erfindung. Der p-Schenkel 10 besteht aus einer alternierenden Folge von polykristallinen $Si_{90}Ge_{10}$-Schichten 2 und polykristallienen $Si_{70}Ge_{30}$-Schichten 3 gemäß Fig. 1. Die $Si_{90}Ge_{10}$-Schichten 2 sind mit $1 \cdot 10^{20}$ Bor-Atomen/$cm^3$ dotiert. Die $Si_{70}Ge_{30}$-Schichten 3 sind nicht dotiert. Die Schichten 2 und 3 haben je eine Dicke von $5 \cdot 10^{-7}$ cm. An jeder Grenzfläche zwischen einer Schicht 2 und 3 ist ein $3 \cdot 10^{-7}$ cm dicker Film 7 aus amorphem $Si_x Ge_{1-x} O_2$ zur Passivierung - d. h. zur Reduzierung der hohen Defekt-Dichten zwischen den Korngrenzen der polykristallinen Schichten - aufgebracht. Der p-Schenkel enthält insgesamt $2,5 \cdot 10^5$ Schichten 2, 3 und 7, die parallel zum Wärmestrom 1 verlaufen. Der n-Schenkel 11 besteht ganz analog aus einer alternierenden Folge von polykristallinen $Si_{90}Ge_{10}$-Schichten 2 und $Si_{70}Ge_{30}$-Schichten 3 gemäß Fig. 1. Die $Si_{90}Ge_{10}$-Schichten 2 sind jedoch hier mit $2 \cdot 10^{20}$ Phosphor-Atomen/$cm^3$ dotiert. Die $Si_{70}Ge_{30}$-Schichten sind im n-Schenkel 11 ebenfalls nicht dotiert. Die Dicke der Schichten 2 und 3 im n-Schenkel 11 beträgt je $5 \cdot 10^{-7}$ cm. An jeder Grenzfläche zwischen einer Schicht 2 und 3 ist ebenfalls ein $3 \cdot 10^{-7}$ cm dicker Passivierungsfilm 7 aus amorphem $Si_x Ge_{1-x} O_2$ aufgebracht. Die Schichten 2, 3 und 7 sind bei Substrat-Temperaturen von $250 \,^{\circ} C$ bis $320 \,^{\circ} C$ abgeschieden. Der n-Schenkel 11 enthält insgesamt $2,5 \cdot 10^5$ Schichten 2, 3 und 7, die parallel zum Wärmestrom 1 verlaufen. Die Thermoelement-Schenkel 10 und 11 haben quadratischen Querschnitt bei einem Durchmesser von 4 mm. Ihre Länge beträgt 6 mm. Sie sind über die metallischen Brücken 12 elektrisch leitend miteinander verbunden. Ihre anderen Enden tragen elektrisch-thermische Kontakte 13, die auf der Temperatur $T = T_0$ festgehalten sind. Die metallische Brücke hat als Folge des Wärmestromes 1 die Temperatur $T_h > T_0$. Die durch Umwandlung von Wärme erzeugte elektrische Energie wird durch den elektrischen Verbraucher 15 aufgenommen. Da die Effektivitäten des p-Schenkels 10 und des n-Schenkels 11 etwa um den Faktor 40 größer sind als von den entsprechenden massiven SiGe-Kristallen, hat das Thermoelement einen Arbeitsfaktor $A \approx 10$. Da das Thermoelement für Meßzwecke zwischen den Temperaturen $T_H \approx 550 \,^{\circ} K$ und $T_0 \approx 78 \,^{\circ} K$ arbeitet, ist sein maximaler Wirkungsgrad $\eta \leqq 57\%$.

Ausführungsbeispiel 7

zeigt in Fig. 7 einen Thermogenerator, der durch die elektrische Serienschaltung und thermische Parallelschaltung von Thermoelementen entstanden ist, welche aus p-leitenden Thermoelement-Schenkeln 10 und n-leitenden Thermoelement-Schenkeln 11 gemäß der Erfindung aufgebaut sind. Sowohl die p-leitenden Thermoelement-Schenkel 10 als auch die n-leitenden Thermoelement-Schenkel 11 weisen eine Struktur von multiplen parallelen dünnen Drähten 8 in einer Matrix 9 von Bornitrid auf. Die Drähte 8 in dem p-leitenden Thermoelement-Schenkel 10 bestehen aus reinem Eisen und die Drähte 8 in den n-leitenden Thermoelement-Schenkeln 11 bestehen aus Nickel. Die Strukturen in den p-leitenden und n-leitenden Thermoelement-Schenkeln sind auch nach der gleichen Methode hergestellt. Die Fig. 7a und 7b verdeutlichen schematisch den Ausgangsprozeß für ihre Herstellung. Fig. 7a zeigt einen 30 mm dicken und 300 mm langen Draht oder besser Stab 8' aus Eisen bzw. aus Nickel, der sich zentral in einem Eisen- bzw. Nickel-Rohr 16 befindet, welches einen Außendurchmesser von 100 mm, eine Wandstärke von 25 mm und eine Länge von 350 mm hat. Dieses Rohr 16 hat an seinen Enden Innengewinde, in welche 25 mm dicke Abschluß-Bolzen aus Eisen bzw. Nickel eingeschraubt werden können, welche den Stab 8' aus Eisen bzw. Nickel in seiner zentralen Lage festhalten. Der 1 cm dicke Zwischenraum zwischen dem Stab 8' und der Innenwandung des Rohres 16 ist mit amorphem Bornitrid (7') gefüllt, welches mit 5000 kg/$cm^2$ verdichtet ist. Die Abschluß-Bolzen aus Eisen bzw. Nickel sind danach so eingeschraubt, daß keine Hohlräume im Rohr 16 vorhanden sind. Das so gefüllte Rohr 16 wird unter Schutzgas auf Rotglut erhitzt und durch Rollen unter hohem Druck, sowie langsamem Ziehen, in mehreren Stufen in seinem Außen-durchmesser bis auf 20 mm bei einer Länge von 8750 mm verkleinert. Da Bornitrid ein Schichtgitter besitzt, verhält es sich bei diesem Verkleinerungsprozeß wie eine inerte inkompressible Flüssigkeit. Danach werden aus dem 20 mm dicken Ziehstrang neunzehn gleichlange Teile von etwa 380 mm Länge geschnitten. Die 5 mm dicke Ummantelung aus Eisen bzw. Nickel wird von jedem der 19 Abschnitte mechanisch (durch Drehen oder Schleifen) abgenommen. Die 19 Abschnitte, welche danach nur noch je 1 cm dick sind, werden als Paket - wie in Bild 7b gezeigt - in ein zweites Rohr 16 aus Eisen bzw. Nickel mit einem Innendurchmesser von 50 mm (Außendurchmesser wieder 100 mm) und einer Länge von 430 mm gesteckt. In die Zwischenräume, zwischen die 1 cm dicken Abschnitte, wird Bornitrid unter einem Druck von 5000 kg/cm$^2$ eingefüllt. Nach Einschrauben der Abschluß-Bolzen aus Eisen bzw. Nickel wird dieses Rohr 16 wiederum bei Rotglut durch Rollen unter hohem Druck und Ziehen in mehreren Stufen bis auf einen Außendurchmesser 20 mm (bei einer Länge von ca. 10 750 mm) verdünnt. Danach erfolgt wiederum das Zerlegen in 19 Abschnitte, die Abnahme des 5 mm dicken Außenmantels, das Einfüllen des 19teiligen Abschnitt-Paketes in ein neues Rohr 16 aus Eisen bzw. Nickel und so fort. Nach insgesamt 10 nacheinander folgenden Roll- und Ziehprozessen der beschriebenen Art hat man einen 20 mm dicken und etwa 9 200 mm langen Stab erhalten, der mit einem 5 mm dicken Mantel aus Eisen bzw. Nickel überzogen ist. Aus diesem Stab lassen sich etwa 900 Abschnitte mit je 10 mm Länge schneiden. Wenn man wiederum von jedem Abschnitt die 5 mm dicke Ummantelung aus Eisen bzw. Nickel entfernt, dann erhält man 900 Thermoelement-Schenkel mit einem Durchmesser von 1 cm und einer Länge von 1 cm. Die im Bornitrid 9 eingebetteten Eisen- bzw. Nickel-Drähte 8 haben nur noch einen mittleren Durchmesser von etwa $3 \cdot 10^{-7}$ cm. Die Zahl der parallelen dünnen Drähte in einem Thermoelement-Schenkel 10 oder 11 beträgt etwa $3 \cdot 10^{11}$. Der kleinste mittlere Abstand zwischen zwei Drähten beträgt etwa $1,5 \cdot 10^{-7}$ cm. Diese p-leitenden und n-leitenden Thermoelement-Schenkel lassen sich auch mit Hilfe von Eisen- bzw. Nickel-Pulver nach der gleichen Methode herstellen. Wenn man in das Rohr 16 anstelle des Stabes 8' aus Eisen bzw. Nickel und des Bornitrids 7' ein Gemisch aus 35 Volumen-% Eisenpulver bzw. Nickelpulver - mit Durchmessern der Eisenpartikel 8' bzw. Nickelpartikel 8' von $5 \cdot 10^{-3}$ cm - und 65 Volumen-% Bornitridpulver 7' unter hohem Druck einfüllt, das Rohr wie beschrieben verschließt und in seinem Durchmesser auf 20 mm reduziert, dann erhält man auch hier einen Ziehstrang von 8750 mm Länge. Daraus lassen sich 19 Abschnitte herstellen. Nach Entfernen des Eisen-bzw. Nickelmantels werden die 19 Abschnitte - wie beschrieben - in einem neuen Rohr 16 untergebracht, wieder im Durchmesser auf 20 mm reduziert und so fort. Schon nach der vierten Durchmesser-Reduzierung sind aus den Eisenpartikeln 8' bzw. Nickelpartikeln 8' Drähte mit einer mehrfachen Länge des Ziehstrangs geworden. Nach sechs Reduktionsvorgängen liegt der Durchmesser der Eisendrähte 8 bzw. Nickeldrähte 8 bei etwa $3 \cdot 10^{-7}$ cm. Das Ladungsträger-Gas in den Drähten ist senkrecht zur Drahtachse und senkrecht zum Wärmestrom quantisiert. In Richtung des Wärmestromes ist die Bewegung der Ladungsträger frei - aber viel stärker gestreut als im massiven Drahtmaterial. Außerdem ist die Ladungsträger-Dichte stark reduziert. Die dünnen Drähte haben als Folge davon - in Richtung zur Drahtachse - einen "spezifischen elektrischen Widerstand" der um den Faktor 100 größer ist als im massiven Eisen bzw. Nickel. Die spez. Wärmeleitfähigkeit ist ebenfalls um den Faktor 100 reduziert. Da aber auch die differentielle Thermokraft um den Faktor 100 größer ist als zwischen massivem Eisen und Nickel, sind die Effektivitäten dieser Thermoelement-Schenkel und die Arbeitsfaktoren der aus ihnen hergestellten Thermoelemente um den Faktor $10^4$ größer als bei konventionellen Thermoelementen mit Eisen und Nickel-Schenkeln. Die Arbeitsfaktoren der Thermoelemente im Thermogenerator in Fig. 4 liegen bei $A \approx 100$. In einer Schutzgas-Atmosphäre arbeitet der Thermogenerator zwischen $T_h \approx 1200$ $^\circ$K und $T_0 \approx 370$ $^\circ$K im Dauerbetrieb. Er kann dabei einen Wirkungsgrad $\eta$ der Umwandlung von Wärme in elektrische Energie von $\eta \leq 60$ % erreichen. Der Thermogenerator gemäß Fig. 4 ist in 56 quadratischen Heizungsrohren 17 von je 40 mm$^2$ Innenquerschnitt bei einer Länge von 750 mm untergebracht. Die Heizungsrohre 17 sind - wie in Fig. 7c dargestellt - zu einem wassergekühlten Heizblock 18 mit den Außenmaßen 750 mm Länge, 500 mm Breite und 450 mm Höhe zusammengefaßt. In jedem der 56 Heizungsrohre 17 befinden sich - elektrisch isoliert voneinander - die metallisch leitenden Brücken von 4 x 34 = 136 elektrisch zu einem Thermogenerator in Serie geschalteten Thermoelementen. Durch die Verbrennung von regelbar zugeführten Brennstoff-Luftgemischen werden die jeweils 136 metallisch leitenden Brücken der 56 Thermogeneratoren in den 56 Heizungsrohren 17 auf kurzfristig veränderbare Temperaturen bis maximal $T_h$ = 1200 $^\circ$K (927 $^\circ$C) erhitzt. Die 56 Thermogeneratoren in den 56 Heizungsrohren sind durch elektrische Parallelschaltung zu einer thermoelektrischen Generator-Anlage zusammengefaßt. Da ein einzelnes Thermoelement in dieser Anlage etwa einen maximalen Innenwiderstand von 100 mΩ hat, beträgt der maximale Innenwiderstand der thermoelektrischen Generatoranlage etwa 0,25Ω. Jedes Thermoelement hat bei einer maximalen Temperaturdifferenz von 830 $^\circ$ eine Leerlaufspannung von 2,8 V. Die maximale Kurzschluß-Leistung der Anlage beträgt deshalb etwa 580 kW. Die maximal entnehmbare elektrische Leistung liegt bei 145 kW, wobei dann der Wirkungsgrad etwa 30 % ist. Bei einer Leistungsentnahme von nur 80 kW steigt der Wirkungsgrad auf über 50 %.

Bezugszeichen

| | |
|---|---|
| 1 | Wärmestrom |
| 2 | Schichten aus hochdotiertem einkristallinem Halbleitermaterial |
| 3 | Schichten aus nichtdotiertem oder nur schwach dotiertem einkristallinem Halbleitermaterial mit kleinerem Bandabstand als 2 |
| 4 | Matrix aus dotiertem einkristallinem Halbleitermaterial |
| 5 | Dünne Drähte aus nichtdotiertem oder nur schwach dotiertem einkristallinem Halbleitermaterial mit kleinerem Bandabstand als 4 |
| 6 | Dünner metallisch leitender Film |
| 7 | Dünner Isolatorfilm oder hochohmiger Halbleiterfilm |
| 7' | Isolator oder hochohmiger Halbleiter |
| 8 | Dünner metallisch leitender Draht |
| 8' | Metallisch leitender Stab, Draht, dicker Film oder metallisches Pulverteilchen |
| 9 | Isolatormatrix oder hochohmige Halbleitermatrix |
| 10 | p-leitender thermoelektrischer Schenkel |
| 11 | n-leitender thermoelektrischer Schenkel |
| 12 | Metallische Brücke zwischen 10 und 11 |
| 13 | Elektrisch-thermischer Kontakt am Thermoelement-Schenkel auf der festgehaltenen Temperatur $T = T_0$ |
| 14 | Stromquelle |
| 15 | Elektrischer Verbraucher |
| 16 | Metall-Rohr |
| 17 | Heizungsrohr mit quadratischem Querschnitt |
| 18 | Wassergekühlter Heizungsblock |

**Patentansprüche**

1. Thermoelement-Schenkel mit richtungsabhängiger Quantisierung der Ladungsträger, dadurch gekennzeichnet, daß ein Thermoelement-Schenkel aus einer Struktur von multiplen alternierenden dünnen Schichten, Drähten oder Filmen besteht, welche parallel zum Wärmestrom (1) durch den Thermoelement-Schenkel verlaufen, daß die Dicke der dünnen Schichten, Drähte oder Filme kleiner ist als die freie Weglänge oder die De Broglie-Wellenlänge der Ladungsträger in den dünnen Schichten, Drähten oder Filmen, so daß die Bewegung der Ladungsträger senkrecht zum Wärmestrom (1) durch den Thermoschenkel mindestens in einer Richtung quantisiert ist, und daß die Bewegung der Ladungsträger parallel zum Wärmestrom durch den Thermoelement-Schenkel frei ist.

2. Thermoelement-Schenkel, nach Anspruch 1 dadurch gekennzeichnet, daß die Struktur aus multiplen dünnen Schichten durch ein Übergitter von alternierenden Schichten aus dotiertem Halbleitermaterial (2) und nichtdotiertem oder nur schwach dotiertem Halbleitermaterial (3) mit geringerem Bandabstand als das dotierte Halbleitermaterial (2) gebildet ist.

3. Thermoelement-Schenkel, nach Anspruch 1 dadurch gekennzeichnet, daß eine Struktur von multiplen alternierenden dünnen Halbleiter-Drähten durch eine dotierte Halbleitermatrix(4) gebildet ist, in welche parallele dünne einkristalline Drähte (5) aus nichtdotiertem oder nur schwach dotiertem Halbleitermaterial mit kleinerem Bandabstand als die dotierte Halbleitermatrix (4) eingebettet sind.

4. Thermoelement-Schenkel, nach Anspruch 1 dadurch gekennzeichnet, daß die Struktur von multiplen alternierenden dünnen Drähten oder dünnen Filmen durch parallele dünne metallisch leitende Drähte (8) gebildet ist, welche in eine Isolatormatrix (9) oder in eine hochohmige Halbleitermatrix (9) eingebettet sind, oder durch Isolator-Filme (7) oder hochohmige Halbleiterfilme (7) gebildet ist, welche abwechselnd mit dünnen metallisch leitenden Filmen (6) ein Filmpaket bilden.

5. Thermoelement-Schenkel, nach Anspruch 1 dadurch gekennzeichnet, daß die Struktur von multiplen dünnen Drähten oder Filmen dadurch entsteht, daß in einen Isolator (7') oder in einen hochohmigen Halbleiter (7') eine Vielzahl von parallelen metallisch leitenden Drähten (8') dicken Filmen (8') oder metallischen Pulverteilchen (8') eingebettet ist, daß die Dicke dieser Drähte (8'), Filme (8') oder Pulverteilchen (8') größer als die freie Weglänge oder die De Broglie-Wellenlänge der Ladungsträger in den Drähten (8'), Filmen (8') oder Pulverteilchen (8') ist, und daß durch mechanisches Rollen, Ziehen, Walzen oder Pressen bei erhöhter Temperatur die Dimensionen des gesamten Einbettungssystems so geändert werden, daß die resultierende Dicke der eingebetteten Drähte (8), Filme (6) oder der zu Drähten (8) verformten Pulverteilchen kleiner als die freie Weglänge oder die De Broglie-Wellenlänge der Ladungsträger in den Drähten (8) oder Filmen (6) ist.

6. Thermoelement-Schenkel, nach Anspruch 1 dadurch gekennzeichnet, daß die Struktur von multiplen alternierenden dünnen Schichten (2), (3) oder Drähten (5) in einer Halbleitermatrix (4) aus Elementhalbleitern oder Verbindungshalbleitern wie z. B. III/V-Verbindungen, IV/IV-Mischkristallen, IV/IV-Verbindungen oder II/VI-Verbindungen gebildet ist.

7. Thermoelement-Schenkel, nach Anspruch 1 dadurch gekennzeichnet, daß die multiplen alternierenden dünnen Drähte oder dünnen Filme aus Metallen, Legierungen oder metallisch leitenden Verbindungen wie Carbiden, Boriden, Nitriden, Sulfiden, Seleniden, Telluriden, Oxiden oder deren Verbindungen bestehen, und daß diese eingebettet sind in eine Isolatormatrix oder eine hochohmige Halbleitermatrix bzw. zwischen dünnen Isolatorfilmen oder dünnen hochohmigen Halbleiterfilmen, welche aus Gläsern, organischen Kunststoffen, Oxiden, Nitriden, Sulfiden, Seleniden, Telluriden, Chloriden, Fluoriden, Elementhalbleitern oder Verbindungshalbleitern bestehen.

8. Thermoelement-Schenkel, nach Anspruch 1 dadurch gekennzeichnet, daß die Struktur von multiplen alternierenden dünnen Schichten, Drähten oder Filmen in ansich bekannter Weise mit Hilfe von Molekularstrahl-Epitaxie (MBE), metallorganischem Abscheiden aus der Gasphase (MOCVD) , durch Aufdampfen im Hochvakuum, durch Aufsputtern, durch reaktives Sputtern, durch elektrochemisches Abscheiden, durch elektrochemisches Passivieren bzw. durch eine Kombination dieser Methoden hergestellt ist.

9. Thermoelement-Schenkel, nach Anspruch 1 dadurch gekennzeichnet, daß er in ansich bekannter Weise zur Herstellung von Peltier-Elementen zur reversiblen Kühlung, Heizung oder Klimatisierung benutzt ist.

10. Thermoelement-Schenkel, nach Anspruch 1 dadurch gekennzeichnet, daß er zur Herstellung von Thermoelementen zur Umwandlung von Wärme in elektrische Energie für meßtechnische Zwecke oder zur Erzeugung von Elektrizität aus Wärme als Thermogenerator benutzt ist.

# FIG.1

# FIG.2

# FIG.3

# FIG.4a

# FIG.4 b

# FIG.4c

# FIG.5

$T_c < T_0$  12
1  1
10  11
13  13
$T_0$
−  +
14

# FIG.6

$T_h > T_0$  12
1  1
10  11
13  13
+  −
$T_0$
15

# FIG.7

$T_h > T_0$

# FIG.7a

# FIG.7b

# FIG.7c

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE-A-3 541 710 (K. BOJAK) <br> * Ganzes Dokument * <br> --- | 1-2,4-10 | H 01 L 35/18 <br> H 01 L 35/20 <br> H 01 L 35/22 <br> H 01 L 35/32 |
| Y | WO-A-7 900 968 (WESTERN ELECTRIC CO.) <br> * Seite 3, Zeile 1 - Seite 4, Zeile 14; Figur 1 * <br> --- | 1-2,6,8-10 | |
| Y | PHYSICAL REVIEW B. CONDENSED MATTER, Band 27, Nr. 10, Mai 1983, The American Physical Society, New York, US; M.J. BURNS et al.: "Thermoelectric power of two-dimensional Pd and Pd-Au films" <br> * Seite 5924, Absatz: "Introduction"; Seite 5932, Absatz: "Discussion" * <br> --- | 4,5,7 | |
| D,A | JOURNAL OF APPL. PHYS., Band 66, Nr. 3, 1. August 1989, Seiten 1222-1226, American Institute of Physics, New York, US; S.J. ALLEN et al.: "Filamentary structure and transport in corrugated InGaAs/InP superlattices grown by vapor levitation epitaxy" <br> * Seite 1223, Absatz: "III. Experiment" * <br> --- | 3 | **RECHERCHIERTE SACHGEBIETE (Int. Cl.5)** <br><br> H 01 L 35/00 |
| A | US-A-4 465 895 (ECD-ANR ENERGY CONVERSION CO.) <br> * Ganzes Dokument * <br> ----- | 1,9-10 | |

Der vorliegende Recherchenbericht wurde für alle Patentansprüche erstellt

| Rechercheort | Abschlußdatum der Recherche | Prüfer |
|---|---|---|
| DEN HAAG | 14-09-1990 | ZEISLER P.W. |

EPO FORM 1503 03.82 (P0403)